(19) **Europäisches Patentamt / European Patent Office / Office européen des brevets**

(11) **EP 4 542 818 A1**

(12) **EUROPEAN PATENT APPLICATION**
published in accordance with Art. 153(4) EPC

(43) Date of publication:
**23.04.2025 Bulletin 2025/17**

(21) Application number: **23896453.0**

(22) Date of filing: **03.11.2023**

(51) International Patent Classification (IPC):
**H02J 7/00** (2006.01)    **H05K 7/20** (2006.01)

(52) Cooperative Patent Classification (CPC):
**B60R 16/02; F04D 27/00; H02J 7/00; H02J 50/10; H05K 7/20**

(86) International application number:
**PCT/CN2023/129722**

(87) International publication number:
**WO 2024/114299 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.11.2022 CN 202211526999**

(71) Applicant: **Nio Smart Technology Co., Ltd.**
**Shanghai 201800 (CN)**

(72) Inventor: **ZHAO, Dongxing**
**Shanghai 201804 (CN)**

(74) Representative: **Vossius & Partner**
**Patentanwälte Rechtsanwälte mbB**
**Siebertstrasse 3**
**81675 München (DE)**

(54) **CONTROL METHOD FOR VEHICLE-MOUNTED WIRELESS CHARGER, VEHICLE-MOUNTED WIRELESS CHARGER, AND VEHICLE**

(57)    A control method for an on-board wireless charger, an on-board wireless charger and a vehicle are provided in the present invention. To this end, the control method for the on-board wireless charger according to the present invention dynamically adjusts a fan module and a semiconductor module respectively, so that a heat dissipation state of the on-board wireless charger can better meet the actual requirement of heat dissipation, the fan module and the semiconductor module can be reasonably adjusted to realize self-adaptive intelligent regulation. The problem of energy waste caused by an excessive heat dissipation capacity of the on-board wireless charger can be solved, and user experience is improved.

FIG. 3

**Description**

The present application claims priority to Chinese Patent Application No. CN202211526999.4 filed on November 30, 2022, entitled "CONTROL METHOD FOR ON-BOARD WIRELESS CHARGER, ON-BOARD WIRELESS CHARGER AND VEHICLE", which is incorporated into the present application by reference in its entirety.

**TECHNICAL FIELD**

The present invention relates to the technical field of vehicles, and particularly provides a control method for an on-board wireless charger, an on-board wireless charger and a vehicle.

**BACKGROUND**

With the rapid development of electronic devices (such as mobile phones) and wireless fast charging technology, automobiles have started to be equipped with wireless chargers to meet the need of users for charging mobile terminals (such as mobile phones) while being driven. In order to solve the problem that the temperature of an on-board wireless charger rapidly increases during the charging of a mobile phone, air cooling-based heat dissipation or semiconductor-based heat dissipation is usually adopted to dissipate the heat of the on-board wireless charger, achieving the purpose of dissipating the heat of the on-board wireless charger during the charging of the mobile phone.

At present, since the charging power of the mobile phone gradually decreases as the increase of battery level and the heat loss of the charging channel also gradually decreases as the decrease of power, only a low heat dissipation capacity is needed to meet the requirement of heat dissipation in the later stage of charging. However, the conventional on-board wireless charger cannot flexibly adjust the operating state of the fan module according to requirements of heat dissipation, leading to energy waste caused by the excessive heat dissipation capability of the fan module and other problems.

Therefore, a novel control method is required in the art to solve the aforementioned problems.

**SUMMARY**

The present invention is intended to solve the aforementioned technical problem, i.e. the problem that a conventional on-board wireless charger cannot dynamically adjust the requirement of heat dissipation according to a charging state, leading to energy waste.

In a first aspect, the present invention provides a control method for an on-board wireless charger, where the on-board wireless charger is mounted on a vehicle and configured to charge a mobile terminal; the mobile terminal is configured with a first NTC module and a first MIC module, where the first NTC module is configured to detect a temperature of the mobile terminal, and the first MIC module is configured to detect noise in a vehicle's interior environment; the on-board wireless charger is configured with a fan module, a semiconductor module, a charging coil module, a power conversion module, a second NTC module, a third NTC module, and a second MIC module, where the power conversion module is connected with the vehicle to charge the mobile terminal, the second NTC module is connected with the charging coil module to detect a temperature of the charging coil module, the third NTC module is connected with the semiconductor module to detect a temperature of the semiconductor module, and the second MIC module is configured to detect noise of the wireless charging module charging the mobile terminal; and the control method includes the following steps: acquiring a first temperature value $T_1$ of the charging coil module and a second temperature value $T_2$ of the mobile terminal, and comparing the first temperature value $T_1$ with an $n_1^{th}$ preset temperature value $Tsn_1$ and an $n_1+1^{th}$ preset temperature value $Tsn_1+1$, and the second temperature value $T_2$ with a $n_2$th preset temperature value $Tfn_2$ and a $nn_2+1^{th}$ preset temperature value $Tfn_2+1$; and/or during charging performed by the on-board wireless charger, acquiring a first noise value $S_1$ of the on-board wireless charger charging the mobile terminal and/or a second noise value $S_2$ of the vehicle's interior environment, and comparing the first noise value $S_1$ and/or the second noise value $S_2$ with an $n_3^{th}$ preset noise value $Shn_3$ and a $n_3+1^{th}$ preset noise value $Shn_3+1$; determining an operating rotational speed of the fan module according to a comparison result; and controlling the fan module to operate according to the operating rotational speed, where $n_1$, $n_2$ and $n_3$ are all positive integers greater than or equal to 1.

In a preferred technical solution of the aforementioned control method, "determining an operating rotational speed of the fan module according to a comparison result" includes the following step: if $Tsn_1+1 < T_1 \leq Tsn_1$ and $Tfn_2+1 < T_2 \leq Tfn_2$, calculating an operating rotational speed $R_s$ of the fan module; or if $Shn_3+1 < S_1 \leq Shn_3$ and/or $Shn_3+1 < S_2 \leq Shn_3$, calculating an operating rotational speed $R_h$ of the fan module; or if $Shn_3+1 < S_1 \leq Shn_3$ and/or $Shn_3 S_2 \leq Shn_3$, $Tsn_1+1 < T_1 \leq Tsn_1$ and $Tfn_2+1 < T_2 \leq Tfn_2$, calculating an operating rotational speed $R_f$ of the fan module.

In a preferred technical solution of the aforementioned control method, "determining an operating rotational speed of the fan module according to a comparison result" further includes the following step: determining the operating

rotational speed $R_s$ by calculation according to the following formula: $R_s=R_{max}-(n_1-1)R_1-(n_2-1)R_2$, where $R_s$ is the operating rotational speed, $R_{max}$ is a maximum operating rotational speed of the fan module, $R_1$ is a rotational speed reduction corresponding to a unit temperature decrease of the charging coil module, and $R_2$ is a rotational speed reduction corresponding to a unit temperature decrease of the mobile terminal; or determining the operating rotational speed $R_h$ by calculation according to the following formula: $R_h=R_{max}-(n_3-1)R_3$, where $R_h$ is the operating rotational speed, and $R_3$ is a rotational speed reduction corresponding to a unit noise decrease of the wireless charger charging the mobile terminal or a unit noise decrease of the vehicle's interior environment; or determining the operating rotational speed $R_f$ by calculation according to the following formula: $R_f=R_{max}-(n_1-1)R_1-(n_2-1)R_2-(n_3-1)R_3$, where $R_f$ is the operating rotational speed.

In a preferred technical solution of the aforementioned control method, "determining an operating rotational speed of the fan module according to a comparison result" specifically includes: determining an operating voltage of the fan module according to the comparison result so as to determine the operating rotational speed of the fan module, which includes the following step: if $Tsn_1+1<T_1 \leq Tsn_1$ and $Tfn_2+1<T_2 \leq Tfn_2$, calculating an operating voltage $U_a$ of the fan module; or if $Shn_3+1<S_1 \leq Shn_3$ and/or $Shn_3+1<S_2 \leq Shn_3$, calculating an operating voltage $U_b$ of the fan module; or if $Shn_3+1<S_1 \leq Shn_3$ and/or $Shn_3+1<S_2 \leq Shn_3$, $Tsn_1+1<T_1 \leq Tsn_1$ and $Tfn_2+1<T_2 \leq Tfn_2$, calculating an operating voltage $U_c$ of the fan module.

In a preferred technical solution of the aforementioned control method, "determining an operating voltage of the fan module according to a comparison result" further includes the following step: determining the operating voltage $U_a$ by calculation according to the following formula: $U_a=U_{max1}-(n_1-1)U_5-(n_2-1)U_6$, where $U_a$ is the operating voltage, $U_{max1}$ is a maximum operating voltage of the fan module, $U_5$ is a voltage reduction of the fan module corresponding to a unit temperature decrease of the charging coil module, and $U_6$ is a voltage reduction of the fan module corresponding to a unit temperature decrease of the charging coil module; or determining the operating voltage $U_b$ by calculation according to the following formula: $U_b=U_{max1}-(n_3-1)U_7$, where $U_b$ is the operating voltage, and $U_7$ is a voltage reduction of the fan module corresponding to a unit noise decrease of the wireless charger charging the mobile terminal or a unit noise decrease of the vehicle's interior environment; or determining the operating voltage $U_c$ by calculation according to the following formula: $U_c=U_{max1}-(n_1-1)U_5-(n_2-1)U_6-(n_3-1)U_7$, where $U_c$ is the operating voltage.

In a preferred technical solution of the aforementioned control method, $T_{s1}$ is a maximum temperature value of the charging coil module; and/or $T_{f1}$ is a maximum temperature value of the mobile terminal; and/or $R_{s1}$ is a maximum operating rotational speed of the fan module.

In a preferred technical solution of the aforementioned control method, a third temperature value $T_3$ of the semiconductor module is acquired, and the third temperature value $T_3$ is compared with an $n_4\text{th}$ preset temperature value $Tdn_4$ and an $n_4+1\text{th}$ preset noise value $Tdn_4+1$; and an operating rotational speed of the fan module is determined according to a comparison result, where $n_4$ is a positive integer greater than or equal to 1.

In a preferred technical solution of the aforementioned control method, $T_{d1}$ is a minimum temperature value of the semiconductor module.

In a preferred technical solution of the control method, "determining an operating rotational speed of the fan module according to a comparison result" includes the following step: if $Tdn_4+1<T_3 \leq Tdn_4$, $Tsn_1+1<T_1 \leq Tsn_1$ and $Tfn_2+1<T_2 \leq Tfn_2$, calculating an operating rotational speed $R_a$ of the fan module; or if $Tdn_4+1<T_3 \leq Tdn_4$, $Shn_3+1<S_1 \leq Shn_3$ and/or $Shn_3+1<S_2 \leq Shn_3$, calculating an operating rotational speed $R_b$ of the fan module; or if $Tdn_4+1 < T_3 \leq Tdn_4$, $Shn_3+1 < S_1 \leq Shn_3$ and/or $Shn_3+1 < S_2 \leq Shn_3$, $Tsn_1+1 < T_1 \leq Tsn_1$ and $Tfn_2+1<T_2 \leq Tfn_2$, calculating an operating rotational speed $R_c$ of the fan module.

In a preferred technical solution of the aforementioned control method, the operating rotational speed $R_a$ is determined by calculation according to the following formula: $R_a=R_{max}-(n_1-1)R_1-(n_2-1)R_2-(n_4-1)R_4$, where $R_a$ is the operating rotational speed, $R_4$ is a rotational speed reduction corresponding to a unit temperature increase of the semiconductor module; or the operating rotational speed $R_b$ is determined by calculation according to the following formula: $R_b=R_{max}-(n_3-1)R_3-(n_4-1)R_4$, where $R_b$ is the operating rotational speed; or the operating rotational speed $R_c$ is determined by calculation according to the following formula: $R_c=R_{max}-(n_1-1)R_1-(n_2-1)R_2-(n_3-1)R_3-(n_4-1)R_4$, where $R_c$ is the operating rotational speed.

In a preferred technical solution of the aforementioned control method, an operating voltage of the semiconductor module is determined according to a comparison result, including the following step: if $Tdn_4+1<T_3 \leq Tdn_4$, $Tsn_1+1<T_1 \leq Tsn_1$ and $Tfn_2+1<T_2 \leq Tfn_2$, calculating an operating voltage $U_s$ of the semiconductor module; or if $Tdn_4+1<T_3 \leq Tdn_4$, $Shn_3+1 < S_1 \leq Shn_3$ and/or $Shn_3+1 < S_2 \leq Shn_3$, calculating an operating voltage $U_h$ of the semiconductor module; or if $Tdn_4+1<T_3 \leq Tdn_4$, $Shn_3+1 < S_1 \leq Shn_3$ and/or $Shn_3+1 < S_2 \leq Shn_3$, $Tsn_1+1 < T_1 \leq Tsn_1$ and $Tfn_2+1 < T_2 \leq Tfn_2$, calculating an operating voltage $U_f$ of the semiconductor module.

In a preferred technical solution of the aforementioned control method, "determining an operating voltage of the semiconductor module according to a comparison result" further includes the following step: determining the operating voltage $U_s$ by calculation according to the following formula: $U_s=U_{max2}-(n_1-1)U_1-(n_2-1)U_2-(n_4-1)U_4$, where $U_s$ is the operating voltage, $U_{max2}$ is a maximum operating voltage of the semiconductor module, $U_1$ is a voltage reduction of the semiconductor module corresponding to a unit temperature decrease of the charging coil module, $U_2$ is a voltage reduction of the semiconductor module corresponding to a unit temperature decrease of the mobile terminal, and $U_4$ is a voltage reduction of the semiconductor module corresponding to a unit temperature increase of the semiconductor module; or determining the operating voltage $U_h$ by calculation according to the following formula: $U_h=U_{max2}-(n_1-1)U_3-(n_4-1)U_4$, where $U_h$ is the operating voltage, and $U_3$ is a voltage reduction of the semiconductor module corresponding to a unit noise decrease of the wireless charger charging the mobile terminal or a unit noise decrease of the vehicle's interior environment; or determining the operating voltage $U_f$ by calculation according to the following formula: $U_f=U_{max2}-(n_1-1)U_1-(n_2-1)U_2-(n_3-1)U_4-(n_4-1)U_4$, where $U_f$ is the operating voltage.

In a second aspect, the present invention provides an on-board wireless charger, which includes a first control unit capable of executing the control method according to any of the aforementioned preferred technical solutions.

In a third aspect, the present invention provides a vehicle, which includes the on-board wireless charger according to any of the aforementioned preferred technical solutions.

In a preferred technical solution of the aforementioned vehicle, the vehicle includes a second control unit capable of executing the control method according to any of the aforementioned preferred technical solutions.

According to the control method for an on-board wireless charger provided by the present invention, the operating rotational speed of the fan module is adjusted according to the temperature of the charging coil module, the temperature of the mobile phone, the noise and other parameters, so that the operating rotational speed of the fan module can be dynamically adjusted, and then the operating state of the fan module better meets the actual requirement of heat dissipation, solving the problem of the energy waste caused by the excessive heat dissipation capacity of the fan module.

Further, an operating voltage of the fan module is determined according to a comparison result, including the following step: if $Tsn_1+1<T_1 \leq Tsn_1$ and $Tfn_2+1<T_2 \leq Tfn_2$, calculating an operating voltage $U_a$ of the fan module; or if $Shn_3+1 < S_1 \leq Shn_3$ and/or $Shn_3+1 < S_2 \leq Shn_3$, calculating an operating voltage $U_b$ of the fan module; or if $Shn_3+1<S_1 \leq Shn_3$ and/or $Shn_3+1<S_2 \leq Shn_3$, $Tsn_1+1<T_1 \leq Tsn_1$ and $Tfn_2+1<T_2 \leq Tfn_2$, calculating an operating voltage $U_c$ of the fan module. By controlling a voltage of power supplied to the fan module by the power conversion module, the operating rotational speed of the fan module can be further adjusted, so that the fan module can be controlled in a diversified way.

Further, the control method further includes: acquiring a third temperature value $T_3$ of the semiconductor module, and comparing the third temperature value $T_3$ with an $n_4{}^{th}$ preset temperature value $Tdn_4$ and an $n_4+1{}^{th}$ preset noise value $Tdn_4+1$; and determining an operating rotational speed of the fan module according to a comparison result, where $n_4$ is a positive integer greater than or equal to 1. The control method can also dynamically adjust the semiconductor module, so that the operating state of the semiconductor module can better meet the actual requirement of heat dissipation, and can also solve the problem of the energy waste caused by the excessive heat dissipation capacity of the fan module.

Further, an operating voltage of the semiconductor module is determined according to the comparison result, including the following step: if $Tdn_4+1<T_3 \leq Tdn_4$, $Tsn_1+1<T_1 \leq Tsn_1$ and $Tfn_2+1 <T_2 \leq Tfn_2$, calculating an operating voltage $U_s$ of the semiconductor module; or if $Tdn_4+1<T_3 \leq Tdn_4$ and $Shn_3+1<S_1 \leq Shn_3$ and/or $Shn_3+1<S_2 \leq Shn_3$, calculating an operating voltage $U_h$ of the semiconductor module; or if $Tdn_4+1<T_3 \leq Tdn_4$ and $Shn_3+1<S_1 \leq Shn_3$ and/or $Shn_3 +1<S_2 \leq Shn_3$, $Tsn_1+1<T_1 \leq Tsn_1$ and $Tfn_2+1<T_2 \leq Tfn_2$, calculating an operating voltage $U_f$ of the semiconductor module. By controlling the voltage of the power supplied to the semiconductor module by the power conversion module, the operating state of the semiconductor module can be further adjusted, so that the semiconductor module can be controlled in the diversified way, better meeting the actual requirement of heat dissipation.

**BRIEF DESCRIPTION OF DRAWINGS**

Preferred implementations of the present invention will be described below with reference to the accompanying drawings. Among the accompanying drawings:

Fig. 1 is a working flowchart of a mobile phone according to an embodiment of the present invention;

Fig. 2 is a working flowchart of an on-board wireless charger according to an embodiment of the present invention;

Fig. 3 is a schematic flowchart of a first embodiment of a control method for an on-board wireless charger according to the present invention;

Fig. 4 is a schematic flowchart of a second embodiment of the control method for an on-board wireless charger according to the present invention;

Fig. 5 is a schematic flowchart of a third embodiment of the control method for an on-board wireless charger according to the present invention;

Fig. 6 is a schematic flowchart of a fourth embodiment of the control method for an on-board wireless charger according to the present invention;

Fig. 7 is a schematic flowchart of a fifth embodiment of the control method for an on-board wireless charger according to the present invention; and

Fig. 8 is a schematic flowchart of a sixth embodiment of the control method for an on-board wireless charger according to the present invention.

## DETAILED DESCRIPTION

Preferred implementations of the present invention will be described below with reference to the accompanying drawings. It should be understood by those skilled in the art that these implementations are merely intended to explain the technical principles of the present invention rather than limit the protection scope of the present invention. For example, although a mobile terminal in the present invention is described as a mobile phone in the present specification, the technical solutions of the present invention are not limited to this, that is, the mobile terminal in the present invention may also be a tablet computer, a watch, or other devices, as long as such a change of an application object does not depart from the principles and scope of the present invention.

It should be noted that in the description of the present invention, directions or positional relations indicated by terms, such as "upper", "lower", "internal" and "external", are directions or positional relations shown in the accompanying drawings, which are merely intended to facilitate description rather than indicate or imply that the devices or elements must have specific directions and be structured and operated according to the specific directions, and therefore should not be interpreted as limitations to the present invention. In addition, the terms "first", "second" and "third" are merely intended for description rather than interpreted as indicating or implying relative importance.

In addition, it should also be noted that in the description of the present invention, unless otherwise specified and defined, the terms "connect", "arrange" and "mount" should be broadly understood as, for example, "fixedly connect", "detachably connect" or "integrally connect"; "mechanically connect"; or "directly interconnect" or "indirectly interconnect through an intermediate". For those skilled in the art, the specific meanings of the aforementioned terms in the present invention may be understood according to specific conditions.

Aiming at the problem that a conventional on-board wireless charger cannot dynamically adjust the requirement of heat dissipation according to a charging state, leading to energy waste, the present invention provides a control method for an on-board wireless charger, an on-board wireless charger and a vehicle, which can dynamically adjust a fan module, so that a heat dissipation state of the fan module can better meet the actual requirement of heat dissipation, the fan module can be reasonably adjusted to realize self-adaptive intelligent regulation. The problem of energy waste caused by an excessive heat dissipation capacity of the fan module can be solved, and user experience is improved.

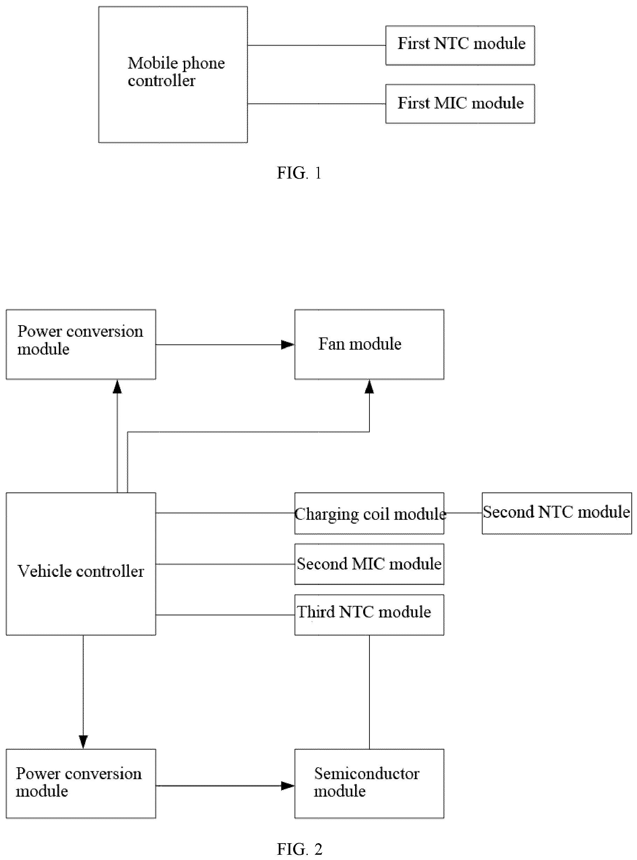

First, referring to Figs. 1 and 2, a mobile phone and the on-board wireless charger according to the present invention will be described. Fig. 1 is a working flowchart of the mobile phone according to an embodiment of the present invention; and Fig. 2 is a working flowchart of the on-board wireless charger according to an embodiment of the present invention.

As shown in Fig. 1, the mobile phone is configured with a first NTC module and a first MIC module, where the first NTC module is configured to detect a temperature of the mobile phone; and the first MIC module is configured to detect noise in a vehicle's interior environment.

As shown in Fig. 2, the on-board wireless charger is configured with a fan module, a semiconductor module, a charging coil module, a power conversion module, a second NTC module, a third NTC module, and a second MIC module, where the power conversion module is connected with the vehicle, so as to charge the mobile phone; the second NTC module is connected with the charging coil module, so as to detect a temperature of the charging coil module; the third NTC module is connected with the semiconductor module, so as to detect a temperature of the semiconductor module; and the second MIC module is configured to detect noise of the wireless charging module charging the mobile phone.

Preferably, a vehicle controller can transmit PWM signals to the power conversion module and the fan module, so as to control an operating state of the on-board wireless charger.

Preferably, the power conversion module can also supply power to the fan module and the semiconductor module, so that the fan module and the semiconductor module can dissipate heat of the mobile phone.

Further, the fan module supplies air into an air-cooling channel through rotation, so as to achieve a purpose of dissipating the heat of the mobile phone; and the semiconductor module transfers a cooling capacity to the mobile phone through refrigeration, so as to achieve the purpose of dissipating the heat of the mobile phone.

Preferably, the mobile phone may be connected to the vehicle through Bluetooth or WIFI, so that the temperature of the mobile phone and the noise in the vehicle's interior environment can be transmitted to the vehicle controller, and the on-board wireless charger can be controlled by the vehicle controller or a mobile phone controller.

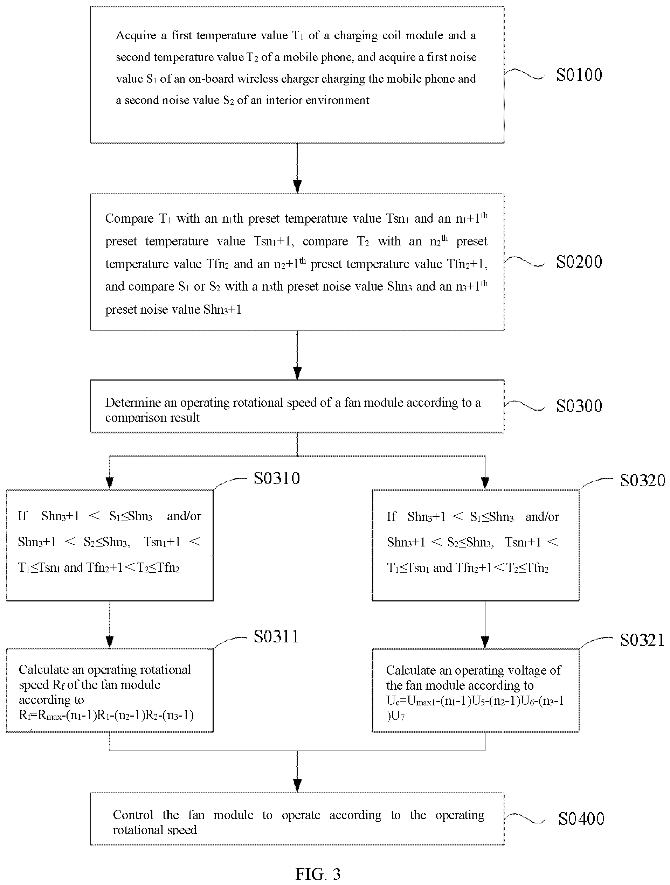

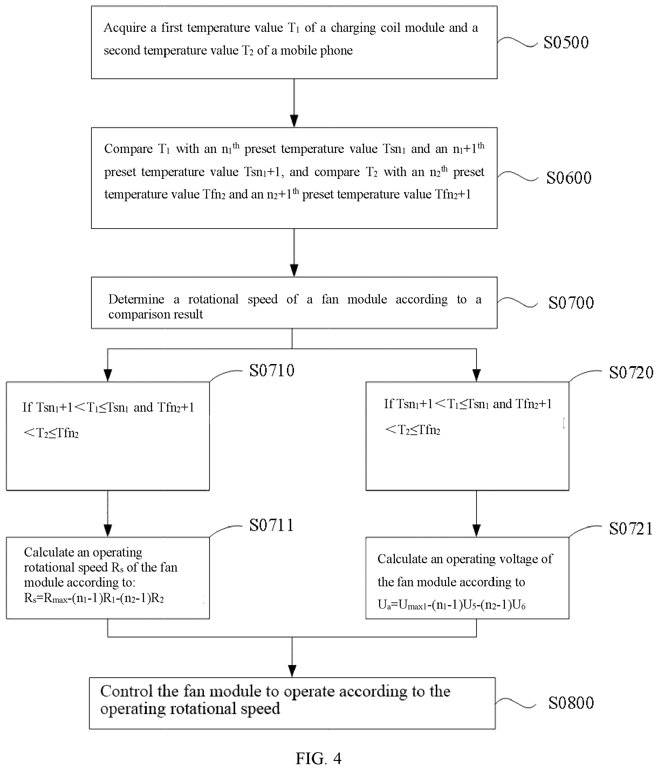

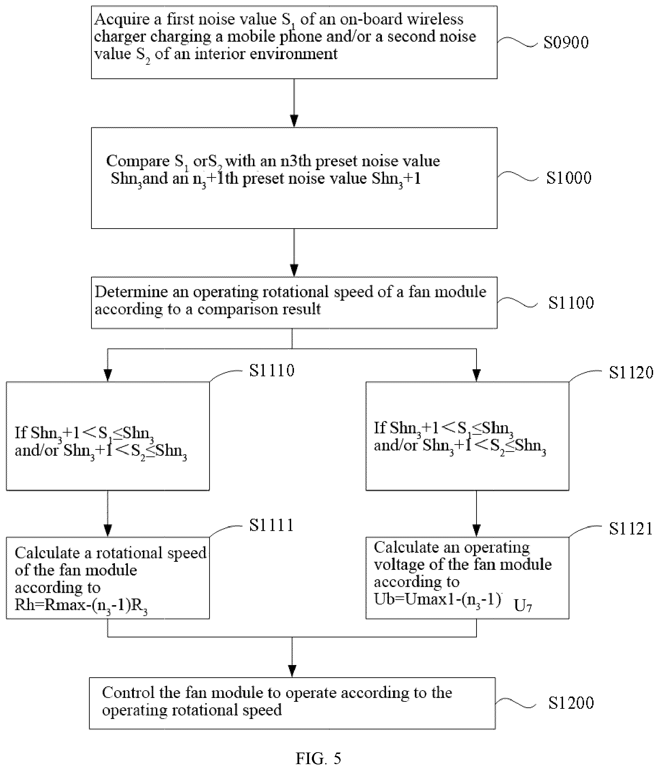

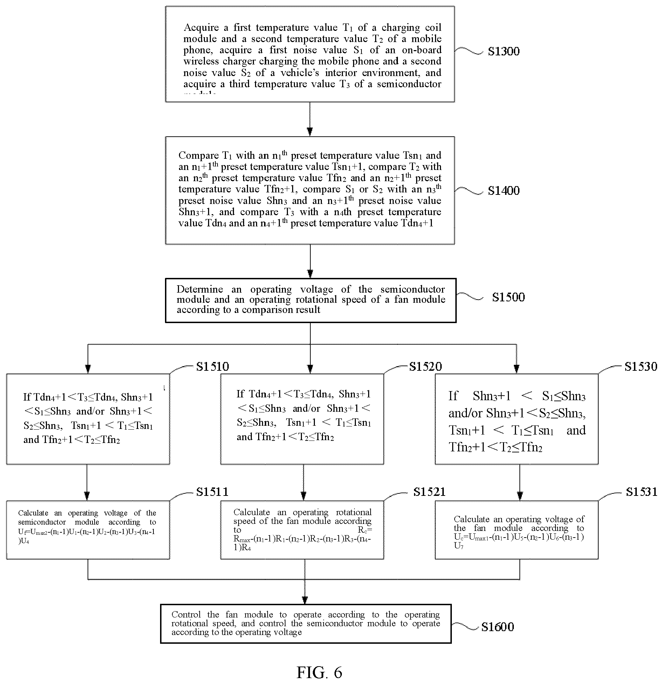

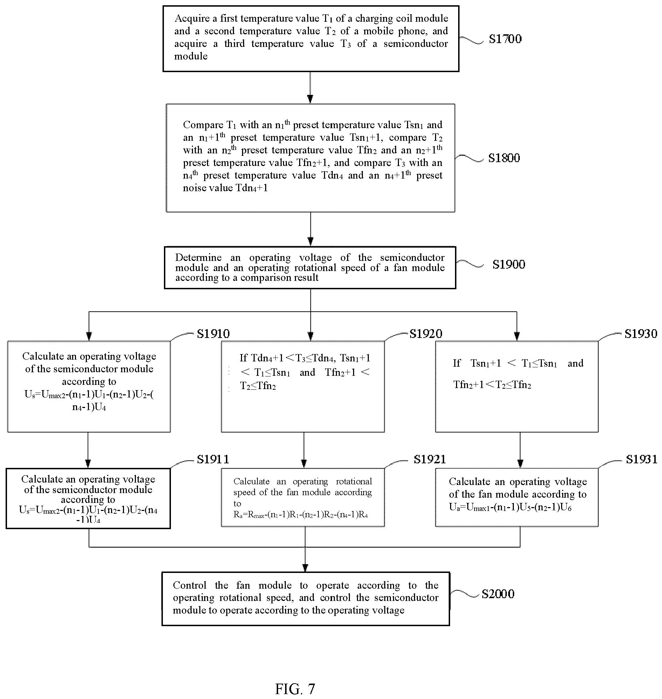

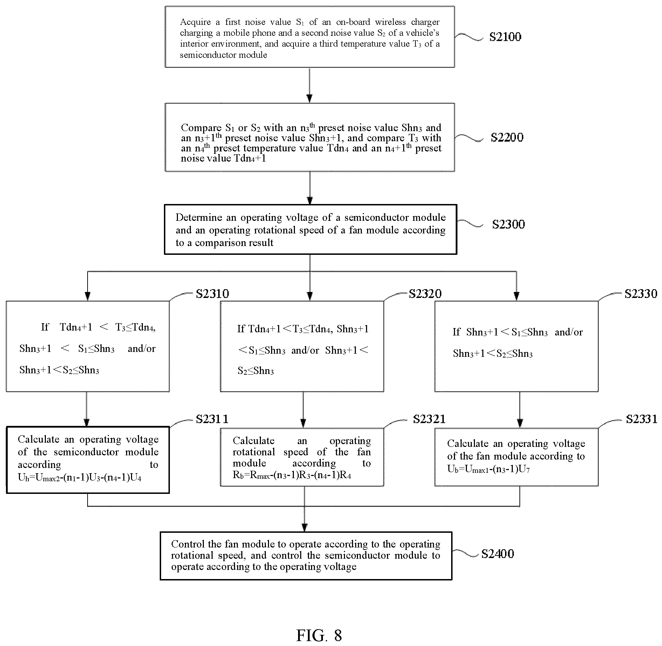

Referring to Figs. 3 to 8, the control method for the on-board wireless charger according to the present invention will be described below. Fig. 3 is a schematic flowchart of a first embodiment of the control method for the on-board wireless charger according to the present invention; Fig. 4 is a schematic flowchart of a second embodiment of the control method for the on-board wireless charger according to the present invention; Fig. 5 is a schematic flowchart of a third embodiment of the control method for the on-board wireless charger according to the present invention; Fig. 6 is a schematic flowchart of a fourth embodiment of the control method for the on-board wireless charger according to the present invention; Fig. 7 is a schematic flowchart of a fifth embodiment of the control method for the on-board wireless charger according to the present invention; and Fig. 8 is a schematic flowchart of a sixth embodiment of the control method for the on-board wireless charger according to the present invention.

The control method for the on-board wireless charger will be described below in conjunction with the following embodiments.

Embodiment 1

As shown in Fig. 3, the control method for the on-board wireless charger in the embodiment of the present invention mainly includes Steps S0100 to S0400 below.

At Step S0100, a first temperature value $T_1$ of the charging coil module and a second temperature value $T_2$ of the mobile phone are acquired, and a first noise value $S_1$ of the on-board wireless charger charging the mobile phone and a second noise value $S_2$ of the vehicle's interior environment are acquired.

Preferably, the first temperature value $T_1$ is acquired by the second NTC module, and the second temperature value $T_2$ is acquired by the first NTC module; the first noise value $S_1$ is acquired by the second MIC module, and the second noise value $S_2$ is acquired by the first MIC module.

At Step S0200, $T_1$ is compared with an $n_1^{th}$ preset temperature value $Tsn_1$ and an $n_1+1^{th}$ preset temperature value $Tsn_1+1$, $T_2$ is compared with a $n_2$th preset temperature value $Tfn_2$ and an $n_2+1^{th}$ preset temperature value $Tfn_2+1$, and $S_1$ or $S_2$ is compared with an $n_3^{th}$ preset noise value $Shn_3$ and an $n_3+1^{th}$ preset noise value $Shn_3+1$.

Specifically, the preset temperature values Ts, Tf and the preset noise values Sh are divided into a plurality of preset ranges, and $T_1$, $T_2$, $S_1$ and $S_2$ acquired are then compared with the preset ranges respectively. For example, the preset temperature values Ts may be divided into four ranges, i.e. $60°C < Tsn_1 \leq 50°C$, $50°C < Tsn_1 \leq 40°C$, $40°C < Tsn_1 \leq 30°C$ and $30°C < Tsn_1 \leq 20°C$, and a maximum temperature value of the charging coil module is $60°C$, i.e. $Ts_1 = T_{smax} = 60°C$, $Ts_2 = 50°C$, $Ts_3 = 40°C$, $Ts_4 = 30°C$ and $Tss = 20°C$. When the first temperature value $T_1$ acquired is $36°C$, at this point, $n_1 = 3$, and $Ts_4 < T_1 \leq Ts_3$. For another example, the preset temperature values Tf may be divided into four ranges, i.e. $50°C < Tfn_2 \leq 40°C$, $40°C < Tfn_2 \leq 30°C$, $30°C < Tfn_2 \leq 20 °C$ and $20°C < Tfn_2 \leq 10°C$, and a maximum temperature value of the mobile phone is $50°C$, i.e. $Tf_1 = T_{fmax} = 50°C$, $Ts_2 = 40°C$, $Ts_3 = 30°C$, $Ts_4 = 20°C$ and $Ts_5 = 10°C$. When the second temperature value $T_2$ acquired is $28°C$, at this point, $n_2 = 3$, and $Tf_4 < T_1 \leq Tf_3$. The preset noise values Sh may be divided into four ranges, i.e. $70 dB < S_1/S_2 \leq 60 dB$, $60 dB < S_1/S_2 \leq 50 dB$, $50 dB < S_1/S_2 \leq 40 dB$ and $40 dB < S_1/S_2 \leq 30 dB$, calculation is based on 70 dB if 70 dB is exceeded, and a maximum noise value of the charging coil module charging the mobile phone or a maximum noise value of the vehicle's interior environment is 70 dB, i.e. $Sh_1 = S_{hmax} = 70 dB$, $Sh_2 = 60 dB$, $Sh_3 = 50 dB$, $Sh_4 = 40 dB$ and $Sh_5 = 30 dB$. When the first noise value $S_1$ or the second noise value $S_2$ acquired is 45 dB, at this point, $n_3 = 3$, and $Sh_4 < S_1/S_2 \leq Sh_3$.

Preferably, when the vehicle is driven, because driving noise is greater than operating noise of the on-board wireless charger, $S_2$ is compared with the $n_3^{th}$ preset noise value $Shn_3$ and the $n_3+1^{th}$ preset noise value $Shn_3+1$; and when the vehicle is parked, because the operating noise of the on-board wireless charger is greater than the noise inside the vehicle during parking, $S_1$ is compared with the $n_3^{th}$ preset noise value $Shn_3$ and the $n_3+1^{th}$ preset noise value $Shn_3+1$.

At Step S0300, an operating rotational speed of the fan module is determined according to a comparison result.

At Step S0400, the fan module is controlled to operate according to the operating rotational speed.

It should be noted that $n_1$, $n_2$ and $n_3$ are all positive integers greater than or equal to 1.

It should be noted that an order of acquiring the first temperature value $T_1$, the second temperature value $T_2$, the first noise value $S_1$ and the second noise value $S_2$ is not limited to the aforementioned order. For example, the first noise value $S_1$ and the second noise value $S_2$ may also be acquired first before the first temperature value $T_1$ and the second temperature value $T_2$ are acquired. For another example, the first temperature value $T_1$, the second temperature value $T_2$, the first noise value $S_1$ and the second noise value $S_2$ may also be acquired simultaneously. The present invention does not impose any limitation to the order.

The operating rotational speed of the fan module may be directly controlled by the controller, so that the fan module can rotate according to the determined rotational speed, or an operating voltage of the fan module may be controlled by the controller, so as to determine the operating rotational speed of the fan module. When the fan module is directly controlled by the controller, the operating rotational speed of the fan module is determined by a temperature of the charging coil module, a temperature of the mobile phone and noise, and at this point, the control method for the on-board wireless charger includes the following steps:

At Step S0310, if $Shn_3+1<S_1\leq Shn_3$ and/or $Shn_3+1 < S_2\leq Shn_3$, $Tsn_1+1<T_1\leq Tsn_1$ and $Tfn_2+1<T_2\leq Tfn_2$, then Step S0311 is executed;

At Step S0311, an operating rotational speed $R_f$ of the fan module is calculated according to $R_f=R_{max}-(n_1-1)R_1-(n_2-1)R_2-(n_3-1)R_3$, where $R_f$ is an operating rotational speed of the fan module, $R_{max}$ is a maximum operating rotational speed of the fan module, $R_1$ is a rotational speed reduction corresponding to a unit temperature decrease of the charging coil module, $R_2$ is a rotational speed reduction corresponding to a unit temperature decrease of the mobile phone, and $R_3$ is a rotational speed reduction corresponding to a unit noise decrease of the wireless charger charging the mobile phone or a rotational speed reduction corresponding to a unit noise decrease of the vehicle's interior environment.

Specifically, when the first temperature value $T_1$ acquired is 51°C, the second temperature value $T_2$ acquired is 45°C and the first noise value $S_1$ or the second noise value $S_2$ acquired is 70 dB, at this point, $n_1=1$, $n_2=1$, $n_3=1$, and the fan module is at the maximum operating rotational speed, i.e. $R_f=R_{max}$; $R_1$ is a rotational speed reduction corresponding to a 10°C decrease in the temperature of the charging coil module, $R_2$ is a rotational speed reduction corresponding to a 10°C decrease in the temperature of the mobile phone, and $R_3$ is a rotational speed reduction corresponding to a 10 dB decrease in the noise of the wireless charger charging the mobile phone or a rotational speed reduction corresponding to a 10 dB decrease in the noise of the vehicle's interior environment.

For example, when $n_1$ is 2, $n_2$ is 2, and $n_3$ is 3, if $Sh_4<S_1\leq Sh_3$ and/or $Sh_4<S_2\leq Sh_3$, $Ts_3< T_1\leq Ts_2$ and $Tf_3<T_2\leq Tf_2$, then $R_f=R_{max}-R_1-R_2-2R_3$; and when $n_1$ is 4, $n_2$ is 4, and $n_3$ is 4, if $Sh_5 <S_1\leq Sh_4$ and/or $Sh_5<S_2\leq Sh_4$, $Ts_5<T_1\leq Ts_4$ and $Tf_5<T_2\leq Tf_4$, then $R_f=R_{max}-3R_1-3R_2-3R_3$, where $n_1$, $n_2$ and $n_3$ may be a same value or different values.

When the fan module is directly controlled by the controller and the operating rotational speed of the fan module is determined by the operating voltage of the fan module, the operating rotational speed of the fan module is determined by the temperature of the charging coil module, the temperature of the mobile phone and the noise, and at this point, the control method for the on-board wireless charger includes the following steps:

at Step S0320, if $Shn_3+1 < S_1\leq Shn_3$ and/or $Shn_3+1 < S_2\leq Shn_3$, $Tsn_1+1<T_1\leq Tsn_1$ and $Tfn_2+1<T_2\leq Tfn_2$, then Step S0321 is executed; and

at Step S0321, an operating voltage of the fan module is calculated according to $U_c=U_{max1}-(n_1-1)U_5-(n_2-1)U_6-(n_3-1)U_7$, where $U_c$ is the operating voltage of the fan module, $U_{max1}$ is a maximum operating voltage of the fan module, $U_5$ is a voltage reduction of the fan module corresponding to a unit temperature decrease of the charging coil module, $U_6$ is a voltage reduction of the fan module corresponding to a unit temperature decrease of the mobile phone, and $U_7$ is a rotational speed reduction corresponding to a unit noise decrease of the wireless charger charging the mobile phone or a voltage reduction of the fan module corresponding to a unit noise decrease of the vehicle's interior environment.

Specifically, when the first temperature value $T_1$ acquired is 55°C, the second temperature value $T_2$ acquired is 43 °C and the first noise value $S_1$ or the second noise value $S_2$ acquired is 70 dB, at this point, $n_1=1$, $n_2=1$, $n_3=1$, and the fan module is at the maximum operating voltage, i.e. $U_c=U_{max1}$; Us is a voltage reduction of the fan module corresponding to a 10°C decrease in the temperature of the charging coil module, $U_6$ is a voltage reduction of the fan module corresponding to a 10°C decrease in the temperature of the mobile phone, and $U_7$ is a rotational speed reduction corresponding to a 10 dB decrease in the noise of the wireless charger charging the mobile phone or a voltage reduction of the fan module corresponding to a 10 dB decrease in the noise of the vehicle's interior environment.

For example, when $n_1$ is 3, $n_2$ is 2, and $n_3$ is 2, if $Sh_4<S_1\leq Sh_3$ and/or $Sh_4<S_2\leq Sh_3$, $Ts_3< T_1\leq Ts_2$ and $Tf_3<T_2\leq Tf_2$, then $U_c=U_{max1}-2U_5-U_6-U_7$; and when $n_1$ is 4, $n_2$ is 4, and $n_3$ is 4, if $Sh_5 < S_1\leq Sh_4$ and/or $Sh_5 < S_2\leq Sh_4$, $Ts_5 < T_1\leq Ts_4$ and $Tf_5 < T_2\leq Tf_4$, then $U_c=U_{max1}-3U_5-3U_6-3U_7$, where $n_1$, $n_2$ and $n_3$ may be a same value or different values.

Preferably, $T_{s1}$ is a maximum temperature value of the charging coil module, $Tf_1$ is a maximum temperature value of the mobile phone, and $Rs_1$ is a maximum operating rotational speed of the fan module.

Embodiment 2

As shown in Fig. 4, the control method for the on-board wireless charger in the embodiment of the present invention mainly includes Steps S0500 to S0800 below.

At Step S0500, a first temperature value $T_1$ of the charging coil module and a second temperature value $T_2$ of the mobile phone are acquired.

At Step S0600, $T_1$ is compared with an $n_1$th preset temperature value $Tsn_1$ and an $n_1+1$th preset temperature value $Tsn_1+1$, and $T_2$ is compared with an $n_2$th preset temperature value $Tfn_2$ and an $n_2+1$th preset temperature value $Tfn_2+1$.

At Step S0700, an operating rotational speed of the fan module is determined according to a comparison result.

At Step S0800, the fan module is controlled to operate according to the operating rotational speed.

The operating rotational speed of the fan module may be directly controlled by the controller, so that the fan module can rotate according to the determined rotational speed, or an operating voltage of the fan module may be controlled by the controller, so as to determine the operating rotational speed of the fan module. When the fan module is directly controlled by the controller, the operating rotational speed of the fan module is determined by the temperature of the charging coil module and the temperature of the mobile phone, and at this point, the control method for the on-board wireless charger includes the following steps:

at Step S0710, if $Tsn_1+1 < T_1 \le Tsn_1$ and $Tfn_2+1 < T_2 \le Tfn_2$, then Step S0711 is executed; and

at Step S0711, an operating rotational speed $R_s$ of the fan module is calculated according to: $R_s = R_{max} - (n_1-1)R_1 - (n_2-1)R_2$, where $R_s$ is the operating rotational speed of the fan module.

For example, when $n_1$ is 1, and $n_2$ is 2, if $Ts_2 < T_1 \le Ts_1$ and $Tf_3 < T_2 \le Tf_2$, then $R_s = R_{max} - R_2$; and when $n_1$ is 3, and $n_2$ is 3, if $Ts_4 < T_1 \le Ts_3$ and $Tf_4 < T_2 \le Tf_3$, then $R_s = R_{max} - 2R_1 - 2R_2$, where $n_1$ and $n_2$ may be a same value or different values.

When the fan module is directly controlled by the controller, and the operating rotational speed of the fan module is determined by the operating voltage of the fan module, the operating rotational speed of the fan module is determined by the temperature of the charging coil module and the temperature of the mobile phone, and at this point, the control method for the on-board wireless charger includes the following steps:

at Step S0720, if $Tsn_1+1 < T_1 \le Tsn_1$ and $Tfn_2+1 < T_2 \le Tfn_2$, then Step S0721 is executed; and

at Step S0721, the operating voltage of the fan module is calculated according to $U_a = U_{max1} - (n_1-1)U_5 - (n_2-1)U_6$, where $U_a$ is the operating voltage of the fan module.

For example, when $n_1$ is 3, and $n_2$ is 2, if $Ts_4 < T_1 \le Ts_3$ and $Tf_3 < T_2 \le Tf_2$, then $U_a = U_{max1} - 2U_5 - U_6$; and when $n_1$ is 4, and $n_2$ is 4, if $Ts_4 < T_1 \le Ts_4$ and $Tf_5 < T_2 \le Tf_4$, then $U_a = U_{max1} - 3U_5 - 3U_6$, where $n_1$ and $n_2$ may be a same value or different values.

Embodiment 3

As shown in Fig. 5, the control method for the on-board wireless charger in the embodiment of the present invention mainly includes Steps S0900 to S1200 below.

At Step S0900, a first noise value $S_1$ of the on-board wireless charger charging the mobile phone and/or a second noise value $S_2$ of the vehicle's interior environment are acquired.

At Step S1000, $S_1$ or $S_2$ is compared with an $n_3$[th] preset noise value $Shn_3$ and an $n_3+1$[th] preset noise value $Shn_3+1$.

At Step S1100, an operating rotational speed of the fan module is determined according to a comparison result.

At Step S1200, the fan module is controlled to operate according to the operating rotational speed.

The operating rotational speed of the fan module may be directly controlled by the controller, so that the fan module can rotate according to the determined operating rotational speed, or the operating voltage of the fan module may be controlled by the controller, so as to determine the operating rotational speed of the fan module. When the fan module is directly controlled by the controller, the operating rotational speed of the fan module is determined by the noise, and at this point, the control method for the on-board wireless charger includes the following steps:

at Step S1110, if $Shn_3+1 < S_1 \le Shn_3$ and/or $Shn_3+1 < S_2 \le Shn_3$, then Step S1111 is executed; and

at Step S1111, the operating rotational speed $R_h$ of the fan module is calculated according to $R_h = R_{max} - (n_3-1)R_3$; where $R_h$ is the operating rotational speed of the fan module.

For example, when $n_3$ is 2, if $Sh_3 < S_1 \le Sh_2$ and/or $Sh_3 < S_2 \le Sh_2$, then $R_h = R_{max} - R_3$; and when $n_3$ is 3, if $Sh_4 < S_1 \le Sh_3$ and/or $Sh_4 < S_2 \le Sh_3$, then $R_h = R_{max} - 2R_3$.

When the fan module is directly controlled by the controller and the operating rotational speed of the fan module is determined by the operating voltage of the fan module, the operating rotational speed of the fan module is determined by the noise, and at this point, the control method for the on-board wireless charger includes the following steps:

at Step S1120, if $Shn_3+1 < S_1 \le Shn_3$ and/or $Shn_3+1 < S_2 \le Shn_3$, then Step S1121 is executed; and

at Step S1121, the operating voltage of the fan module is calculated according to $U_b=U_{max1}-(n_3-1)U_7$, where $U_b$ is the operating voltage of the fan module.

For example, when $n_3$ is 2, if $Sh_3<S_1\leq Sh_2$ and/or $Sh_3<S_2\leq Sh_2$, then $U_b=U_{max1}-U_7$; and when $n_3$ is 4, if $Sh_5<S_1\leq Sh_4$ and/or $Sh_5<S_2\leq Sh_4$, then $U_b=U_{max1}-3U_7$.

Embodiment 4

As shown in Fig. 6, the control method for the on-board wireless charger in the embodiment of the present invention mainly includes Steps S1300 to S1600 below.

At Step S1300, a first temperature value $T_1$ of the charging coil module and a second temperature value $T_2$ of the mobile phone are acquired, a first noise value $S_1$ of the on-board wireless charger charging the mobile phone and a second noise value $S_2$ of the vehicle's interior environment are acquired, and a third temperature value $T_3$ of the semiconductor module is acquired.

Preferably, the third temperature value $T_3$ is acquired by the third NTC module.

It should be noted that an order of acquiring the first temperature value $T_1$, the second temperature value $T_2$, the third temperature value $T_3$, the first noise value $S_1$ and the second noise value $S_2$ is not limited to the aforementioned order. For example, the first noise value $S_1$ and the second noise value $S_2$ may also be acquired first before the first temperature value $T_1$, the second temperature value $T_2$ and the third temperature value $T_3$ are acquired. For another example, the first temperature value $T_1$, the second temperature value $T_2$, the third temperature value $T_3$, the first noise value $S_1$ and the second noise value $S_2$ may also be acquired simultaneously. The present invention does not impose any limitation to the order.

At Step S1400, $T_1$ is compared with an $n_1$th preset temperature value $Tsn_1$ and an $n_1+1$th preset temperature value $Tsn_1+1$, $T_2$ is compared with a $n_2$th preset temperature value $Tfn_2$ and an $n_2+1$th preset temperature value $Tfn_2+1$, $S_1$ or $S_2$ is compared with a $n_3$th preset noise value $Shn_3$ and a $n_3+1$th preset noise value $Shn_3+1$, and $T_3$ is compared with an $n_4$th preset temperature value $Tdn_4$ and an $n_4+1$th preset temperature value $Tdn_4+1$.

Specifically, the preset temperature values Td are divided into a plurality of preset ranges, and $T_3$ acquired is then compared with the preset ranges. For example, the preset temperature values Td may be divided into three ranges, i.e. 20°C $<Tdn_4\leq$10°C, 10°C $<Tdn_4\leq$0°C and 0 °C $<Tdn_4\leq$-10°C, and the lowest temperature of the semiconductor module is -10°C, i.e. $Td_1=Td_{min}=0$°C, $Td_2=10$°C, $Td_3=0$°C and $Td_4=20$°C. When the third temperature value $T_3$ acquired is 7°C, at this point, $n_4=2$, and $Td_3<T_3\leq Td_2$.

At Step S1500, an operating voltage of the semiconductor module and an operating rotational speed of the fan module are determined according to a comparison result.

At Step S1600, the fan module is controlled to operate according to the operating rotational speed, and the semiconductor module is controlled to operate according to the operating voltage.

A refrigeration temperature of the semiconductor module is determined by the operating voltage of the semiconductor module, the operating voltage of the semiconductor module is determined by the temperature of the charging coil module, a temperature of the mobile phone, a temperature of the semiconductor module and noise, and at this point, the control method for the on-board wireless charger includes the following steps:

at Step S1510, if $Tdn_4+1 < T_3\leq Tdn_4$, $Shn_3+1<S_1\leq Shn_3$ and/or $Shn_3+1 < S_2\leq Shn_3$, $Tsn_1+1 <T_1\leq Tsn_1$ and $Tfn_2+1<T_2\leq Tfn_2$, then Step S1511 is executed; and

at Step S1511, the operating voltage of the semiconductor module is calculated according to $U_f=U_{max2}-(n_1-1)U_1-(n_2-1)U_2-(n_3-1)U_3-(n_4-1)U_4$, where $U_f$ is the operating voltage of the semiconductor module, $U_{max2}$ is a maximum operating voltage of the semiconductor module, $U_1$ is a voltage reduction of the semiconductor module corresponding to a unit temperature decrease of the charging coil module, $U_2$ is a voltage reduction of the semiconductor module corresponding to a unit temperature decrease of the mobile phone, $U_3$ is a voltage reduction of the semiconductor module corresponding to a unit noise decrease of the wireless charger charging the mobile phone or a voltage reduction of the semiconductor module corresponding to a unit noise decrease of the vehicle's interior environment, and $U_4$ is a voltage reduction of the semiconductor module corresponding to a unit temperature increase of the semiconductor module.

Specifically, when the first temperature value $T_1$ acquired is 51°C, the second temperature value $T_2$ acquired is 45°C, the third temperature value $T_3$ acquired is -7°C and the first noise value $S_1$ or the second noise value $S_2$ acquired is 70 dB, at this point, $n_1=1$, $n_2=1$, $n_3=1$, $n_4=1$, and the semiconductor module is at the maximum operating voltage, i.e. $U_f=U_{max2}$; $U_1$ is a voltage reduction of the semiconductor module corresponding to a 10°C decrease in the temperature of the charging coil module, $U_2$ is a voltage reduction of the semiconductor module corresponding to a 10°C decrease in the temperature of the mobile phone, $U_3$ is a voltage reduction of the semiconductor module corresponding to a 10 dB decrease in the noise of the wireless charger charging the mobile phone or a voltage reduction of the semiconductor module corresponding to a 10 dB decrease in the noise of the vehicle's interior environment, and $U_4$ is a voltage reduction of the semiconductor module corresponding to a 10°C increase in the temperature of the semiconductor module.

For example, when $n_1$ is 2, $n_2$ is 2, $n_3$ is 3, and $n_4$ is 4, if $Td_5 < T_3 \leq Td_4$, $Sh_4 < S_1 \leq Sh_3$ and/or $Sh_4 < S_2 \leq Sh_3$, $Ts_3 < T_1 \leq Ts_2$ and $Tf_3 < T_2 \leq Tf_2$, then $U_f = U_{max2} - U_1 - U_2 - 2U_3 - 3U_4$; and when $n_1$ is 4, $n_2$ is 4, $n_3$ is 4, and $n_4$ is 4, if $Td_5 < T_3 \leq Td_4$, $Sh_5 < S_1 \leq Sh_4$ and/or $Sh_5 < S_2 \leq Sh_4$, $Ts_5 < T_1 \leq Ts_4$ and $Tf_5 < T_2 \leq Tf_4$, then $U_f = U_{max2} - 3U_1 - 3U_2 - 3U_3 - 3U_4$, where $n_1$, $n_2$, $n_3$ and $n_4$ may be a same value or different values.

The operating rotational speed of the fan module may be directly controlled by the controller, so that the fan module can rotate according to the determined rotational speed, or the operating voltage of the fan module may be controlled by the controller, so as to determine the operating rotational speed of the fan module. When the fan module is directly controlled by the controller, the operating rotational speed of the fan module is determined by the temperature of the charging coil module, the temperature of the mobile phone, the temperature of the semiconductor module and the noise, and at this point, the control method for the on-board wireless charger includes the following steps:

at Step S1520, if $Tdn_4 + 1 < T_3 \leq Tdn_4$, $Shn_3 + 1 < S_1 \leq Shn_3$ and/or $Shn_3 + 1 < S_2 \leq Shn_3$, $Tsn_1 + 1 < T_1 \leq Tsn_1$ and $Tfn_2 + 1 < T_2 \leq Tfn_2$, then Step S1521 is executed; and

at Step S1521, the operating rotational speed of the fan module is calculated according to $R_c = R_{max} - (n_1-1)R_1 - (n_2-1)R_2 - (n_3-1)R_3 - (n_4-1)R_4$, where $R_c$ is the operating rotational speed of the fan module, and $R_4$ is a rotational speed reduction corresponding to a unit temperature increase of the semiconductor module.

Specifically, when the first temperature value $T_1$ acquired is 51°C, the second temperature value $T_2$ acquired is 45°C, the third temperature value $T_3$ acquired is -7°C and the first noise value $S_1$ or the second noise value $S_2$ acquired is 70 dB, at this point, $n_1 = 1$, $n_2 = 1$, $n_3 = 1$, $n_4 = 1$, and the fan module is at the maximum operating rotational speed, i.e. $R_c = R_{max}$; and $R_4$ is a rotational speed reduction of the fan module corresponding to a 10 °C increase in the temperature of the semiconductor module.

For example, when $n_1$ is 2, $n_2$ is 2, $n_4$ is 3, and $n_4$ is 4, if $Td_5 < T_3 \leq Td_4$, $Sh_4 < S_1 \leq Sh_3$ and/or $Sh_4 < S_2 \leq Sh_3$, $Ts_3 < T_1 \leq Ts_2$ and $Tf_3 < T_2 \leq Tf_2$, then $R_c = R_{max} - R_1 - R_2 - 2R_3 - 3R_4$; and when $n_1$ is 4, $n_2$ is 4, $n_4$ is 4, and $n_4$ is 4, if $Td_5 < T_3 \leq Td_4$, $Sh_5 < S_1 \leq Sh_4$ and/or $Sh_5 < S_2 \leq Sh_4$, $Ts_5 < T_1 \leq Ts_4$ and $Tf_5 < T_2 \leq Tf_4$, then $R_c = R_{max} - 3R_1 - 3R_2 - 3R_3 - 3R_4$, where $n_1$, $n_2$, $n_3$ and $n_4$ may be a same value or different values.

When the fan module is directly controlled by the controller, and the operating rotational speed of the fan module is determined by the operating voltage of the fan module, the operating rotational speed of the fan module is determined by the temperature of the charging coil module, the temperature of the mobile phone and the noise, and at this point, the control method for the on-board wireless charger includes the following steps:

at Step S1530, if $Shn_3 + 1 < S_1 \leq Shn_3$ and/or $Shn_3 + 1 < S_2 \leq Shn_3$, $Tsn_{14} + 1 < T_1 \leq Tsn_1$ and $Tfn_2 + 1 < T_2 \leq Tfn_2$, then Step S1531 is executed; and

at Step S1531, the operating voltage of the fan module is calculated according to $U_c = U_{max1} - (n_1-1)U_5 - (n_2-1)U_5 - (n_3-1)U_7$, where $U_c$ is the operating voltage of the fan module.

For example, when $n_1$ is 3, $n_2$ is 2, and $n_3$ is 2, if $Sh_4 < S_1 \leq Sh_3$ and/or $Sh_4 < S_2 \leq Sh_3$, $Ts_3 < T_1 \leq Ts_2$ and $Tf_3 < T_2 \leq Tf_2$, then $U_c = U_{max1} - 2U_5 - U_6 - U_7$; and when $n_1$ is 4, $n_2$ is 4, and $n_3$ is 4, if $Sh_5 < S_1 \leq Sh_4$ and/or $Sh_5 < S_2 \leq Sh_4$, $Ts_5 < T_1 \leq Ts_4$ and $Tf_5 < T_2 \leq Tf_4$, then $U_c = U_{max1} - 3U_5 - 3U_6 - 3U_7$, where $n_1$, $n_2$ and $n_3$ may be a same value or different values.

Embodiment 5

As shown in Fig. 7, the control method for the on-board wireless charger in the embodiment of the present invention mainly includes Steps S1700 to S2000 below.

At Step S1700, a first temperature value $T_1$ of the charging coil module and a second temperature value $T_2$ of the mobile phone are acquired, and a third temperature value $T_3$ of the semiconductor module is acquired.

At Step S1800, $T_1$ is compared with an $n_1$th preset temperature value $Tsn_1$ and an $n_1+1$th preset temperature value $Tsn_1+1$, $T_2$ is compared with an $n_2$th preset temperature value $Tfn_2$ and an $n_2+1$th preset temperature value $Tfn_2+1$, and $T_3$ is compared with an $n_4$th preset temperature value $Tdn_4$ and an $n_4+1$th preset noise value $Tdn_4+1$.

At Step S1900, an operating voltage of the semiconductor module and the operating rotational speed of the fan module are determined according to a comparison result.

At Step S2000, the fan module is controlled to operate according to the operating rotational speed, and the semiconductor module is controlled to operate according to the operating voltage.

A refrigeration temperature of the semiconductor module is determined by the operating voltage of the semiconductor module, the operating voltage of the semiconductor module is determined by a temperature of the charging coil module, a temperature of the mobile phone and a temperature of the semiconductor module, and at this point, the control method for the on-board wireless charger includes the following steps:

at Step S1910, if $Tdn_4+1<T_3\leq Tdn_4$, $Tsn_1+1<T_1\leq Tsn_1$ and $Tfn_2+1<T_2\leq Tfn_2$, then Step S1911 is executed; and

at Step S1911, the operating voltage of the semiconductor module is calculated according to $U_s=U_{max2}-(n_1-1)U_1-(n_2-1)U_2-(n_4-1)U_4$, where $U_s$ is the operating voltage of the semiconductor module.

For example, when $n_1$ is 2, $n_2$ is 2, and $n_4$ is 3, if $Td_4<T_3\leq Td_3$, $Ts_3<T_1\leq Ts_2$ and $Tf_3<T_2\leq Tf_2$, then $U_s=U_{max2}-U_1-U_2-2U_4$; and when $n_1$ is 4, $n_2$ is 4, and $n_4$ is 4, if $Td_5<T_3\leq Td_4$, $Ts_5<T_1\leq Ts_4$ and $Tf_5<T_2\leq Tf_4$, then $U_s=U_{max2}-3U_1-3U_2-3U_4$, where $n_1$, $n_2$ and $n_4$ may be a same value or different values.

The operating rotational speed of the fan module may be directly controlled by the controller, so that the fan module can rotate according to the determined rotational speed, or the operating voltage of the fan module may be controlled by the controller, so as to determine the operating rotational speed of the fan module. When the fan module is directly controlled by the controller, the operating rotational speed of the fan module is determined by the temperature of the charging coil module, the temperature of the mobile phone and the temperature of the semiconductor module, and at this point, the control method for the on-board wireless charger includes the following steps:

at Step S1920, if $Tdn_4+1<T_3\leq Tdn_4$, $Tsn_1+1<T_1\leq Tsn_1$ and $Tfn_2+1<T_2\leq Tfn_2$, then Step S1921 is executed; and

at Step S1921, the operating rotational speed of the fan module is calculated according to $R_a=R_{max}-(n_1-1)R_1-(n_2-1)R_2-(n_4-1)R_4$; where $R_a$ is the operating rotational speed of the fan module.

For example, when $n_1$ is 2, $n_2$ is 2, and $n_4$ is 3, if $Td_4<T_3\leq Td_3$, $Ts_3<T_1\leq Ts_2$ and $Tf_3<T_2\leq Tf_2$, then $R_a=R_{max}-R_1-R_2-2R_4$; and when $n_1$ is 4, $n_2$ is 4, and $n_4$ is 4, if $Td_5<T_3\leq Td_4$, $Ts_5<T_1\leq Ts_4$ and $Tf_5<T_2\leq Tf_4$, then $R_a=R_{max}-3R_1-3R_2-3R_4$, where $n_1$, $n_2$ and $n_4$ may be a same value or different values.

When the fan module is directly controlled by the controller, and the operating rotational speed of the fan module is determined by the operating voltage of the fan module, the operating rotational speed of the fan module is determined by the temperature of the charging coil module and the temperature of the mobile phone, and at this point, the control method for the on-board wireless charger includes the following steps:

at Step S1930, if $Tsn_1+1<T_1\leq Tsn_1$ and $Tfn_2+1<T_2\leq Tfn_2$, then Step S1931 is executed; and

at Step S1931, an operating voltage of the fan module is calculated according to $U_a=U_{max1}-(n_1-1)U_5-(n_2-1)U_6$, where $U_a$ is the operating voltage of the fan module, $U_{max1}$ is a maximum operating voltage of the fan module, $U_5$ is a voltage reduction of the fan module corresponding to a unit temperature decrease of the charging coil module, and $U_6$ is a voltage reduction of the fan module corresponding to a unit temperature decrease of the mobile phone.

For example, when $n_1$ is 3, and $n_2$ is 2, if $Ts_4<T_1\leq Ts_3$ and $Tf_3<T_2\leq Tf_2$, then $U_a=U_{max1}-2U_5-U_6$; and when $n_1$ is 4, and $n_2$ is 4, if $Ts_4<T_1\leq Ts_4$ and $Tf_5<T_2\leq Tf_4$, then $U_a=U_{max1}-3U_5-3U_6$, where $n_1$ and $n_2$ may be the same value or different values.

Embodiment 6

As shown in Fig. 8, the control method for the on-board wireless charger in the embodiment of the present invention mainly includes Steps S2100 to S2400 below.

At Step S2100, a first noise value $S_1$ of the on-board wireless charger charging the mobile phone and a second noise value $S_2$ of the vehicle's interior environment are acquired, and a third temperature value $T_3$ of the semiconductor module is acquired.

At Step S2200, $S_1$ or $S_2$ is compared with an $n_3$th preset noise value $Shn_3$ and an $n_3+1$th preset noise value $Shn_3+1$, and $T_3$ is compared with a $n_4$th preset temperature value $Tdn_4$ and an $n_4+1$th preset noise value $Tdn_4+1$.

At Step S2300, an operating voltage of the semiconductor module and an operating rotational speed of the fan module are determined according to a comparison result.

At Step S2400, the fan module is controlled to operate according to the operating rotational speed, and the semiconductor module is controlled to operate according to the operating voltage.

A refrigeration temperature of the semiconductor module is determined by the operating voltage of the semiconductor module, the operating voltage of the semiconductor module is determined by a temperature of the semiconductor module and noise, and at this point, the control method for the on-board wireless charger includes the following steps:

at Step S2310, if $Tdn_4+1<T_3\leq Tdn_4$, $Shn_3+1<S_1\leq Shn_3$ and/or $Shn_3+1 < S_2\leq Shn_3$, then Step S2311 is executed; and
at Step S2311, the operating voltage of the semiconductor module is calculated according to $U_h=U_{max2}-(n_1-1)$ $U_3-(n_4-1)U_4$, where $U_h$ is the operating voltage of the semiconductor module.

For example, when $n_3$ is 2, and $n_4$ is 3, if $Td_4<T_3\leq Td_3$, $Sh_3<S_1\leq Sh_2$ and/or $Sh_3< S_2\leq Sh_2$, then $U_h=U_{max2}-U_3-2U_4$; and when $n_3$ is 4, and $n_4$ is 4, if $Td_5<T_3\leq Td_4$, $Sh_5<S_1\leq Sh_4$ and/or $Sh_5<S_2\leq Sh_4$, then $U_h=U_{max2}-3U_3-3U_4$, where $n_3$ and $n_4$ may be a same value or different values.

The operating rotational speed of the fan module may be directly controlled by the controller, so that the fan module can rotate according to the determined rotational speed, or the operating voltage of the fan module may be controlled by the controller, so as to determine the operating rotational speed of the fan module. When the fan module is directly controlled by the controller, the operating rotational speed of the fan module is determined by the temperature of the semiconductor module and the noise, and at this point, the control method for the on-board wireless charger includes the following steps:

at Step S2320, if $Tdn_4+1<T_3\leq Tdn_4$, $Shn_3+1<S_1\leq Shn_3$ and/or $Shn_3+1 < S_2\leq Shn_3$, then Step S2321 is executed; and
at Step S2321, the operating rotational speed of the fan module is calculated according to $R_b=R_{max}-(n_3-1)R_3-(n_4-1)R_4$, where $R_b$ is the rotational speed of the fan module.

For example, when $n_3$ is 2, and $n_4$ is 3, if $Td_4<T_3\leq Td_3$, $Sh_3<S_1\leq Sh_2$ and/or $Sh_3< S_2\leq Sh_2$, then $R_b=R_{max}-R_3-2R_4$; and when $n_3$ is 4, and $n_4$ is 4, if $Td_5<T_3\leq Td_4$, $Sh_5<S_1\leq Sh_4$ and/or $Sh_5<S_2\leq Sh_4$, then $R_b=R_{max}-3R_3-3R_4$, where $n_3$ and $n_4$ may be a same value or different values.

When the fan module is directly controlled by the controller and the operating rotational speed of the fan module is determined by the operating voltage of the fan module, the operating rotational speed of the fan module is determined by the noise, and at this point, the control method for the on-board wireless charger includes the following steps:

at Step S2330, if $Shn_3+1 < S_1\leq Shn_3$ and/or $Shn_3+1 < S_2\leq Shn_3$, then Step S2331 is executed; and

at Step S2331, the operating voltage of the fan module is calculated according to $U_b=U_{max1}-(n_3-1)U_7$, where $U_b$ is the operating voltage of the fan module, and $U_7$ is a voltage reduction of the fan module corresponding to a unit noise decrease of the wireless charger charging the mobile phone or a unit noise decrease of the vehicle's interior environment.

For example, when $n_3$ is 2, if $Sh_3<S_1\leq Sh_2$ and/or $Sh_3<S_2\leq Sh_2$, then $U_b=U_{max1}-U_7$; and when $n_3$ is 4, if $Sh_5<S_1\leq Sh_4$ and/or $Sh_5<S_2\leq Sh_4$, then $U_b=U_{max1}-3U_7$.

In another aspect, the present invention discloses an on-board wireless charger, which includes a first control unit capable of executing the control method according to any of the aforementioned solutions, and has all the above technical effects, which will not be repeated here again.

In addition, the present invention further discloses a vehicle, which includes the on-board wireless charger according to any of the aforementioned solutions, and has all the above technical effects, which will not be repeated here again.

Preferably, the vehicle further includes a second control unit capable of executing the control method according to any of the aforementioned solutions.

The vehicle may be an electric vehicle, a hybrid electric vehicle, a gasoline vehicle or other vehicles, which will not be listed here.

So far, the technical solution of the present invention has been described in conjunction with the preferred implementations shown in the accompanying drawings, but it is easy for those skilled in the art to understand that the protection scope of the present invention is obviously not limited to these specific implementations. Under the premise of not departing from the principles of the present invention, those skilled in the art can make equivalent changes or substitutions to relevant technical features, and the technical solutions after these changes or substitutions shall all fall within the protection scope of the present invention.

**Claims**

1. A control method for an on-board wireless charger, **characterized in that** the on-board wireless charger is mounted on a vehicle and configured to charge a mobile terminal; the mobile terminal is configured with a first NTC module and a first MIC module, wherein the first NTC module is configured to detect a temperature of the mobile terminal, and the first MIC module is configured to detect noise in a vehicle's interior environment; the on-board wireless charger is configured with a fan module, a semiconductor module, a charging coil module, a power conversion module, a second NTC module, a third NTC module, and a second MIC module, wherein the power conversion module is connected with the vehicle to charge the mobile terminal, the second NTC module is connected with the charging coil module to detect a temperature of the charging coil module, the third NTC module is connected with the semiconductor module to detect a temperature of the semiconductor module, and the second MIC module is configured to detect noise of the wireless charging module charging the mobile terminal; and
the control method comprises the following steps:

   acquiring a first temperature value $T_1$ of the charging coil module and a second temperature value $T_2$ of the mobile terminal, and comparing the first temperature value $T_1$ with an $n_1$th preset temperature value $Tsn_1$ and an $n_1+1$th preset temperature value $Tsn_1+1$, and the second temperature value $T_2$ with an $n_2$th preset temperature value $Tfn_2$ and an $n_2+1$th preset temperature value $Tfn_2+1$; and/or
   during charging performed by the on-board wireless charger, acquiring a first noise value $S_1$ of the on-board wireless charger charging the mobile terminal and/or a second noise value $S_2$ of the vehicle's interior environment, and comparing the first noise value $S_1$ and/or the second noise value $S_2$ with an $n_3$th preset noise value $Shn_3$ and an $n_3+1$th preset noise value $Shn_3+1$;
   determining an operating rotational speed of the fan module according to a comparison result; and
   controlling the fan module to operate according to the operating rotational speed,
   wherein $n_1$, $n_2$ and $n_3$ are all positive integers greater than or equal to 1.

2. The control method according to claim 1, **characterized in that** "determining an operating rotational speed of the fan module according to a comparison result" comprises the following step:

   if $Tsn_1+1<T_1 \leq Tsn_1$ and $Tfn_2+1<T_2 \leq Tfn_2$, calculating an operating rotational speed $R_s$ of the fan module; or
   if $Shn_3+1 < S_1 \leq Shn_3$ and/or $Shn_3+1 < S_2 \leq Shn_3$, calculating an operating rotational speed $R_h$ of the fan module; or
   if $Shn_3+1<S_1 \leq Shn_3$ and/or $Shn_3+1 <S_2 \leq Shn_3$, $Tsn_1+1<T_1 \leq Tsn_1$ and $Tfn_2+1<T_2 \leq Tfn_2$, calculating an operating rotational speed $R_f$ of the fan module.

3. The control method according to claim 2, **characterized in that** "determining an operating rotational speed of the fan module according to a comparison result" further comprises the following steps:

   determining the operating rotational speed $R_s$ by calculation according to the following formula:

   $$R_s=R_{max}-(n_1-1)R_1-(n_2-1)R_2,$$

   wherein $R_s$ is the operating rotational speed, $R_{max}$ is a maximum operating rotational speed of the fan module, $R_1$ is a rotational speed reduction corresponding to a unit temperature decrease of the charging coil module, and $R_2$ is a rotational speed reduction corresponding to a unit temperature decrease of the mobile terminal; or
   determining the operating rotational speed $R_h$ by calculation according to the following formula:

   $$R_h=R_{max}-(n_3-1)R_3,$$

   wherein $R_h$ is the operating rotational speed, and $R_3$ is a rotational speed reduction corresponding to a unit noise decrease of the wireless charger charging the mobile terminal or a unit noise decrease of the vehicle's interior environment; or
   determining the operating rotational speed $R_f$ by calculation according to the following formula:

   $$R_f=R_{max}-(n_1-1)R_1-(n_2-1)R_2-(n_3-1)R_3,$$

   wherein $R_f$ is the rotational speed.

4. The control method according to any of claims 1 to 3, **characterized in that** "determining an operating rotational speed of the fan module according to a comparison result" specifically comprises: determining an operating voltage of the fan module according to the comparison result, so as to determine the operating rotational speed of the fan module, which comprises the following step:

> if $Tsn_1+1 < T_1 \leq Tsn_1$ and $Tfn_2+1 < T_2 \leq Tfn_2$, calculating an operating voltage $U_a$ of the fan module; or
> if $Shn_3+1 < S_1 \leq Shn_3$ and/or $Shn_3+1 < S_2 \leq Shn_3$, calculating an operating voltage $U_b$ of the fan module; or
> if $Shn_3+1 < S_1 \leq Shn_3$ and/or $Shn_3+1 < S_2 \leq Shn_3$, $Tsn_{14}+1 < T_1 \leq Tsn_1$ and $Tfn_2+1 < T_2 \leq Tfn_2$, calculating an operating voltage $U_c$ of the fan module.

5. The control method according to claim 4, **characterized in that** "determining an operating voltage of the fan module according to a comparison result" further comprises the following steps:

> determining the operating voltage $U_a$ by calculation according to the following formula:

$$U_a = U_{max1} - (n_1-1)U_5 - (n_2-1)U_6,$$

> wherein $U_a$ is the operating voltage, $U_{max1}$ is a maximum operating voltage of the fan module, $U_5$ is a voltage reduction of the fan module corresponding to a unit temperature decrease of the charging coil module, and $U_6$ is a voltage reduction of the fan module corresponding to a unit temperature decrease of the charging coil module; or
> determining the operating voltage $U_b$ by calculation according to the following formula:

$$U_b = U_{max1} - (n_3-1)U_7,$$

> wherein $U_b$ is the operating voltage, and $U_7$ is a voltage reduction of the fan module corresponding to a unit noise decrease of the wireless charger charging the mobile terminal or a unit noise decrease of the vehicle's interior environment; or
> determining the operating voltage $U_c$ by calculation according to the following formula:

$$U_c = U_{max1} - (n_1-1)U_5 - (n_2-1)U_6 - (n_3-1)U_7,$$

> wherein $U_c$ is the operating voltage.

6. The control method according to claim 2, **characterized in that** $T_{s1}$ is a maximum temperature value of the charging coil module; and/or

> $T_{f1}$ is a maximum temperature value of the mobile terminal; and/or
> $R_{s1}$ is a maximum operating rotational speed of the fan module.

7. The control method according to claim 3, **characterized in that** the control method further comprises:

> acquiring a third temperature value $T_3$ of the semiconductor module, and comparing the third temperature value $T_3$ with an $n_4$th preset temperature value $Tdn_4$ and an $n_4+1$th preset noise value $Tdn_4+1$; and
> determining an operating rotational speed of the fan module according to a comparison result;
> wherein $n_4$ is a positive integer greater than or equal to 1.

8. The control method according to claim 7, **characterized in that** the control method further comprises:
$T_{d1}$ is a minimum temperature value of the semiconductor module.

9. The control method according to claim 7, **characterized in that** "determining an operating rotational speed of the fan module according to a comparison result" comprises the following step:

> if $Tdn_4+1 < T_3 \leq Tdn_4$, $Tsn_{14}+1 < T_1 \leq Tsn_1$ and $Tfn_2+1 < T_2 \leq Tfn_2$, calculating an operating rotational speed $R_a$ of the fan module; or
> if $Tdn_4+1 < T_3 \leq Tdn_4$, $Shn_3+1 < S_1 \leq Shn_3$ and/or $Shn_3+1 < S_2 \leq Shn_3$, calculating an operating rotational speed $R_b$ of the fan module; or
> if $Tdn_4+1 < T_3 \leq Tdn_4$, $Shn_3+1 < S_1 \leq Shn_3$ and/or $Shn_3+1 < S_2 \leq Shn_3$, $Tsn_1+1 < T_1 \leq Tsn_1$ and $Tfn_2+1 < T_2 \leq Tfn_2$,

calculating an operating rotational speed $R_c$ of the fan module.

10. The control method according to claim 9, **characterized in that** the operating rotational speed $R_a$ is determined by calculation according to the following formula:

$$R_a=R_{max}-(n_1-1)R_1-(n_2-1)R_2-(n_4-1)R_4,$$

wherein $R_a$ is the operating rotational speed, $R_4$ is a rotational speed reduction corresponding to a unit temperature increase of the semiconductor module; or
the operating rotational speed $R_b$ is determined by calculation according to the following formula:

$$R_b=R_{max}-(n_3-1)R_3-(n_4-1)R_4,$$

wherein $R_b$ is the rotational speed; or
the operating rotational speed $R_c$ is determined by calculation according to the following formula:

$$R_c= R_{max}-(n_1-1)R_1-(n_2-1)R_2-(n_3-1)R_3-(n_4-1)R_4;$$

wherein $R_c$ is the operating rotational speed.

11. The control method according to claim 9, **characterized in that** the control method further comprises:
determining an operating voltage of the semiconductor module according to the comparison result, comprising the following step:

if $Tdn_4+1<T_3 \leq Tdn_4$, $Tsn_1+1<T_1 \leq Tsn_1$ and $Tfn_2+1<T_2 \leq Tfn_2$, calculating an operating voltage $U_s$ of the semi-conductor module; or
if $Tdn_4+1 < T_3 \leq Tdn_4$, $Shn_3+1 < S_1 \leq Shn_3$ and/or $Shn_3+1 < S_2 \leq Shn_3$, calculating an operating voltage $U_h$ of the semiconductor module; or
if $Tdn_4+1<T_3 \leq Tdn_4$, $Shn_3+1 < S_1 \leq Shn_3$ and/or $Shn_3+1 < S_2 \leq Shn_3$, $Tsn_1+1 <T_1 \leq Tsn_1$ and $Tfn_2+1 <T_2 \leq Tfn_2$, calculating an operating voltage $U_f$ of the semiconductor module.

12. The control method according to claim 11, **characterized in that** "determining an operating voltage of the semiconductor module according to a comparison result" further comprises the following steps:

determining the operating voltage $U_s$ by calculation according to the following formula:

$$U_s=U_{max2}-(n_1-1)U_1-(n_2-1)U_2-(n_4-1)U_4,$$

wherein $U_s$ is the operating voltage, $U_{max2}$ is a maximum operating voltage of the semiconductor module, $U_1$ is a voltage reduction of the semiconductor module corresponding to a unit temperature decrease of the charging coil module, $U_2$ is a voltage reduction of the semiconductor module corresponding to a unit temperature decrease of the mobile terminal, and $U_4$ is a voltage reduction of the semiconductor module corresponding to a unit temperature increase of the semiconductor module; or
determining the operating voltage $U_h$ by calculation according to the following formula:

$$U_h=U_{max2}-(n_1-1)U_3-(n_4-1)U_4,$$

wherein $U_h$ is the operating voltage, and $U_3$ is a voltage reduction of the semiconductor module corresponding to a unit noise decrease of the wireless charger charging the mobile terminal or a unit noise decrease of the vehicle's interior environment; or
determining the operating voltage $U_f$ by calculation according to the following formula:

$$U_f=U_{max2}-(n_1-1)U_1-(n_2-1)U_2-(n_3-1)U_3-(n_4-1)U_4;$$

wherein $U_f$ is the operating voltage.

13. An on-board wireless charger, **characterized in that** the on-board wireless charger comprises a first control unit, wherein the first control unit can execute the control method according to any of claims 1 to 12.

14. A vehicle, **characterized in that** the vehicle comprises the on-board wireless charger according to claim 13.

15. The vehicle according to claim 14, **characterized in that** the vehicle comprises a second control unit, wherein the second control unit can execute the control method according to any of claims 1 to 12.

```
┌─────────────────────┐                        ┌─────────────────────┐
│                     │────────────────────────│  First NTC module   │
│   Mobile phone      │                        └─────────────────────┘
│   controller        │                        ┌─────────────────────┐
│                     │────────────────────────│  First MIC module   │
└─────────────────────┘                        └─────────────────────┘
```

FIG. 1

```
┌─────────────────────┐                        ┌─────────────────────┐
│  Power conversion   │───────────────────────▶│     Fan module      │
│  module             │                        │                     │
└─────────────────────┘                        └─────────────────────┘
           ▲                                              ▲
           │                                              │
           │         ┌────────────────────────────────────┘
           │         │
┌─────────────────────┐        ┌──────────────────────┐   ┌──────────────────────┐
│                     │────────│ Charging coil module │───│  Second NTC module   │
│                     │        └──────────────────────┘   └──────────────────────┘
│                     │        ┌──────────────────────┐
│  Vehicle controller │────────│  Second MIC module   │
│                     │        └──────────────────────┘
│                     │        ┌──────────────────────┐
│                     │────────│   Third NTC module   │
└─────────────────────┘        └──────────────────────┘
           │                              │
           ▼                              ▼
┌─────────────────────┐        ┌──────────────────────┐
│  Power conversion   │───────▶│    Semiconductor     │
│  module             │        │    module            │
└─────────────────────┘        └──────────────────────┘
```

FIG. 2

17

Acquire a first temperature value $T_1$ of a charging coil module and a second temperature value $T_2$ of a mobile phone, and acquire a first noise value $S_1$ of an on-board wireless charger charging the mobile phone and a second noise value $S_2$ of an interior environment

S0100

Compare $T_1$ with an $n_1$th preset temperature value $Tsn_1$ and an $n_1+1^{th}$ preset temperature value $Tsn_1+1$, compare $T_2$ with an $n_2^{th}$ preset temperature value $Tfn_2$ and an $n_2+1^{th}$ preset temperature value $Tfn_2+1$, and compare $S_1$ or $S_2$ with a $n_3$th preset noise value $Shn_3$ and an $n_3+1^{th}$ preset noise value $Shn_3+1$

S0200

Determine an operating rotational speed of a fan module according to a comparison result

S0300

S0310

If $Shn_3+1 < S_1 \leq Shn_3$ and/or $Shn_3+1 < S_2 \leq Shn_3$, $Tsn_1+1 < T_1 \leq Tsn_1$ and $Tfn_2+1 < T_2 \leq Tfn_2$

S0320

If $Shn_3+1 < S_1 \leq Shn_3$ and/or $Shn_3+1 < S_2 \leq Shn_3$, $Tsn_1+1 < T_1 \leq Tsn_1$ and $Tfn_2+1 < T_2 \leq Tfn_2$

S0311

Calculate an operating rotational speed $R_f$ of the fan module according to $R_f = R_{max} - (n_1-1)R_1 - (n_2-1)R_2 - (n_3-1)$

S0321

Calculate an operating voltage of the fan module according to $U_c = U_{max1} - (n_1-1)U_5 - (n_2-1)U_6 - (n_3-1)U_7$

Control the fan module to operate according to the operating rotational speed

S0400

FIG. 3

Acquire a first temperature value $T_1$ of a charging coil module and a second temperature value $T_2$ of a mobile phone S0500

Compare $T_1$ with an $n_1^{th}$ preset temperature value $Tsn_1$ and an $n_1+1^{th}$ preset temperature value $Tsn_1+1$, and compare $T_2$ with an $n_2^{th}$ preset temperature value $Tfn_2$ and an $n_2+1^{th}$ preset temperature value $Tfn_2+1$ S0600

Determine a rotational speed of a fan module according to a comparison result S0700

S0710

If $Tsn_1+1 < T_1 \leq Tsn_1$ and $Tfn_2+1 < T_2 \leq Tfn_2$

S0720

If $Tsn_1+1 < T_1 \leq Tsn_1$ and $Tfn_2+1 < T_2 \leq Tfn_2$

S0711

Calculate an operating rotational speed $R_s$ of the fan module according to:
$R_s=R_{max}-(n_1-1)R_1-(n_2-1)R_2$

S0721

Calculate an operating voltage of the fan module according to
$U_a=U_{max1}-(n_1-1)U_5-(n_2-1)U_6$

Control the fan module to operate according to the operating rotational speed S0800

FIG. 4

Acquire a first noise value $S_1$ of an on-board wireless charger charging a mobile phone and/or a second noise value $S_2$ of an interior environment ⟞ S0900

Compare $S_1$ or $S_2$ with an n3th preset noise value $Shn_3$ and an $n_3+1$th preset noise value $Shn_3+1$ ⟞ S1000

Determine an operating rotational speed of a fan module according to a comparison result ⟞ S1100

S1110

If $Shn_3+1 < S_1 \leq Shn_3$ and/or $Shn_3+1 < S_2 \leq Shn_3$

S1111

Calculate a rotational speed of the fan module according to $Rh=Rmax-(n_3-1)R_3$

S1120

If $Shn_3+1 < S_1 \leq Shn_3$ and/or $Shn_3+1 < S_2 \leq Shn_3$

S1121

Calculate an operating voltage of the fan module according to $Ub=Umax1-(n_3-1)$ $U_7$

Control the fan module to operate according to the operating rotational speed ⟞ S1200

FIG. 5

```
┌─────────────────────────────────────────────┐
│ Acquire a first temperature value T₁ of a      │
│ charging coil module and a second temperature  │
│ value T₂ of a mobile phone, acquire a first     │        S1300
│ noise value S₁ of an on-board wireless charger  │
│ charging the mobile phone and a second          │
│ noise value S₂ of a vehicle's interior          │
│ environment, and acquire a third temperature    │
│ value T₃ of a semiconductor                     │
└─────────────────────────────────────────────┘
                    │
                    ▼
┌─────────────────────────────────────────────┐
│ Compare T₁ with an n₁ᵗʰ preset temperature     │
│ value Tsn₁ and an n₁+1ᵗʰ preset temperature     │
│ value Tsn₁+1, compare T₂ with an n₂ᵗʰ preset    │
│ temperature value Tfn₂ and an n₂+1ᵗʰ preset     │        S1400
│ temperature value Tfn₂+1, compare S₁ or S₂      │
│ with an n₃ᵗʰ preset noise value Shn₃ and an      │
│ n₃+1ᵗʰ preset noise value Shn₃+1, and compare    │
│ T₃ with a n₄th preset temperature value Tdn₄     │
│ and an n₄+1ᵗʰ preset temperature value Tdn₄+1    │
└─────────────────────────────────────────────┘
```

$Acquire\ a\ first\ temperature\ value\ T_1$ of a charging coil module and a second temperature value $T_2$ of a mobile phone, acquire a first noise value $S_1$ of an on-board wireless charger charging the mobile phone and a second noise value $S_2$ of a vehicle's interior environment, and acquire a third temperature value $T_3$ of a semiconductor — **S1300**

Compare $T_1$ with an $n_1^{th}$ preset temperature value $Tsn_1$ and an $n_1+1^{th}$ preset temperature value $Tsn_1+1$, compare $T_2$ with an $n_2^{th}$ preset temperature value $Tfn_2$ and an $n_2+1^{th}$ preset temperature value $Tfn_2+1$, compare $S_1$ or $S_2$ with an $n_3^{th}$ preset noise value $Shn_3$ and an $n_3+1^{th}$ preset noise value $Shn_3+1$, and compare $T_3$ with a $n_4$th preset temperature value $Tdn_4$ and an $n_4+1^{th}$ preset temperature value $Tdn_4+1$ — **S1400**

Determine an operating voltage of the semiconductor module and an operating rotational speed of a fan module according to a comparison result — **S1500**

**S1510**
If $Tdn_4+1 < T_3 \leq Tdn_4$, $Shn_3+1 < S_1 \leq Shn_3$ and/or $Shn_3+1 < S_2 \leq Shn_3$, $Tsn_1+1 < T_1 \leq Tsn_1$ and $Tfn_2+1 < T_2 \leq Tfn_2$

**S1520**
If $Tdn_4+1 < T_3 \leq Tdn_4$, $Shn_3+1 < S_1 \leq Shn_3$ and/or $Shn_3+1 < S_2 \leq Shn_3$, $Tsn_1+1 < T_1 \leq Tsn_1$ and $Tfn_2+1 < T_2 \leq Tfn_2$

**S1530**
If $Shn_3+1 < S_1 \leq Shn_3$ and/or $Shn_3+1 < S_2 \leq Shn_3$, $Tsn_1+1 < T_1 \leq Tsn_1$ and $Tfn_2+1 < T_2 \leq Tfn_2$

**S1511**
Calculate an operating voltage of the semiconductor module according to $U_f = U_{max2} - (n_1-1)U_1 - (n_2-1)U_2 - (n_3-1)U_3 - (n_4-1)U_4$

**S1521**
Calculate an operating rotational speed of the fan module according to $R_c = R_{max} - (n_1-1)R_1 - (n_2-1)R_2 - (n_3-1)R_3 - (n_4-1)R_4$

**S1531**
Calculate an operating voltage of the fan module according to $U_c = U_{max1} - (n_1-1)U_5 - (n_2-1)U_6 - (n_3-1)U_7$

Control the fan module to operate according to the operating rotational speed, and control the semiconductor module to operate according to the operating voltage — **S1600**

FIG. 6

EP 4 542 818 A1

Acquire a first temperature value $T_1$ of a charging coil module and a second temperature value $T_2$ of a mobile phone, and acquire a third temperature value $T_3$ of a semiconductor module — S1700

Compare $T_1$ with an $n_1^{th}$ preset temperature value $Tsn_1$ and an $n_1+1^{th}$ preset temperature value $Tsn_1+1$, compare $T_2$ with an $n_2^{th}$ preset temperature value $Tfn_2$ and an $n_2+1^{th}$ preset temperature value $Tfn_2+1$, and compare $T_3$ with an $n_4^{th}$ preset temperature value $Tdn_4$ and an $n_4+1^{th}$ preset noise value $Tdn_4+1$ — S1800

Determine an operating voltage of the semiconductor module and an operating rotational speed of a fan module according to a comparison result — S1900

Calculate an operating voltage of the semiconductor module according to $U_s=U_{max2}-(n_1-1)U_1-(n_2-1)U_2-(n_4-1)U_4$ — S1910

If $Tdn_4+1<T_3\leq Tdn_4$, $Tsn_1+1<T_1\leq Tsn_1$ and $Tfn_2+1<T_2\leq Tfn_2$ — S1920

If $Tsn_1+1<T_1\leq Tsn_1$ and $Tfn_2+1<T_2\leq Tfn_2$ — S1930

Calculate an operating voltage of the semiconductor module according to $U_s=U_{max2}-(n_1-1)U_1-(n_2-1)U_2-(n_4-1)U_4$ — S1911

Calculate an operating rotational speed of the fan module according to $R_a=R_{max}-(n_1-1)R_1-(n_2-1)R_2-(n_4-1)R_4$ — S1921

Calculate an operating voltage of the fan module according to $U_a=U_{max1}-(n_1-1)U_5-(n_2-1)U_6$ — S1931

Control the fan module to operate according to the operating rotational speed, and control the semiconductor module to operate according to the operating voltage — S2000

FIG. 7

Acquire a first noise value $S_1$ of an on-board wireless charger charging a mobile phone and a second noise value $S_2$ of a vehicle's interior environment, and acquire a third temperature value $T_3$ of a semiconductor module — S2100

Compare $S_1$ or $S_2$ with an $n_3^{th}$ preset noise value $Shn_3$ and an $n_3+1^{th}$ preset noise value $Shn_3+1$, and compare $T_3$ with an $n_4^{th}$ preset temperature value $Tdn_4$ and an $n_4+1^{th}$ preset noise value $Tdn_4+1$ — S2200

Determine an operating voltage of a semiconductor module and an operating rotational speed of a fan module according to a comparison result — S2300

S2310

If $Tdn_4+1 < T_3 \leq Tdn_4$, $Shn_3+1 < S_1 \leq Shn_3$ and/or $Shn_3+1 < S_2 \leq Shn_3$

S2320

If $Tdn_4+1 < T_3 \leq Tdn_4$, $Shn_3+1 < S_1 \leq Shn_3$ and/or $Shn_3+1 < S_2 \leq Shn_3$

S2330

If $Shn_3+1 < S_1 \leq Shn_3$ and/or $Shn_3+1 < S_2 \leq Shn_3$

S2311

Calculate an operating voltage of the semiconductor module according to $U_h = U_{max2}-(n_1-1)U_3-(n_4-1)U_4$

S2321

Calculate an operating rotational speed of the fan module according to $R_b = R_{max}-(n_3-1)R_3-(n_4-1)R_4$

S2331

Calculate an operating voltage of the fan module according to $U_b = U_{max1}-(n_3-1)U_7$

Control the fan module to operate according to the operating rotational speed, and control the semiconductor module to operate according to the operating voltage — S2400

FIG. 8

## INTERNATIONAL SEARCH REPORT

| International application No. |
| --- |
| **PCT/CN2023/129722** |

**A. CLASSIFICATION OF SUBJECT MATTER**

H02J7/00 (2006.01)i; H05K 7/20(2006.01)i

According to International Patent Classification (IPC) or to both national classification and IPC

**B. FIELDS SEARCHED**

Minimum documentation searched (classification system followed by classification symbols)

IPC:H02J; H05K

Documentation searched other than minimum documentation to the extent that such documents are included in the fields searched

Electronic data base consulted during the international search (name of data base and, where practicable, search terms used)

CNTXT, ENTXTC, CNKI: 蔚来移动, 赵东兴, 充电, 控制, 噪音, 噪声, 温度, 手机, 终端, 车, 环境, 线圈, 半导体, 风机, 风速, 转速, 单位温度, 减少量, control, vehicle??, car?, wireless, charger, speed, fan, terminal+, +phone+, temperature, noise, environment, coil?

**C. DOCUMENTS CONSIDERED TO BE RELEVANT**

| Category* | Citation of document, with indication, where appropriate, of the relevant passages | Relevant to claim No. |
| --- | --- | --- |
| Y | CN 109888867 A (VIVO MOBILE COMMUNICATION CO., LTD.) 14 June 2019 (2019-06-14) description, paragraphs 28-44, 69-74, 79-82, and 167, and figures 1-3 and 5 | 1-2, 4, 6, 13-15 |
| Y | CN 114786441 A (CHERY AUTOMOBILE CO., LTD.) 22 July 2022 (2022-07-22) description, paragraphs 64-74, 98, and 105-125, and figures 1-6 | 1-2, 4, 6, 13-15 |
| A | CN 110875641 A (APPLE INC.) 10 March 2020 (2020-03-10) entire document | 1-15 |
| A | CN 112349999 A (HUAWEI TECHNOLOGIES CO., LTD.) 09 February 2021 (2021-02-09) entire document | 1-15 |
| A | CN 114204629 A (NIO AUTOMOBILE TECHNOLOGY (ANHUI) CO., LTD.) 18 March 2022 (2022-03-18) entire document | 1-15 |
| A | CN 115413204 A (GREAT WALL MOTOR CO., LTD.) 29 November 2022 (2022-11-29) entire document | 1-15 |

☑ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **14 December 2023** | **21 December 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| | International application No. |
|---|---|
| | **PCT/CN2023/129722** |

**C.    DOCUMENTS CONSIDERED TO BE RELEVANT**

| Category* | Citation of document, with indication, where appropriate, of the relevant passages | Relevant to claim No. |
|---|---|---|
| A | CN 113949115 A (GUANGDONG OPPO MOBILE TELECOMMUNICATIONS CORP., LTD.) 18 January 2022 (2022-01-18)<br>entire document | 1-15 |
| A | KR 20180128250 A (ULVAC CRYOGENICS KOREA INC.) 03 December 2018 (2018-12-03)<br>entire document | 1-15 |
| A | US 2019241087 A1 (WITRICITY CORP.) 08 August 2019 (2019-08-08)<br>entire document | 1-15 |

Form PCT/ISA/210 (second sheet) (July 2022)

**INTERNATIONAL SEARCH REPORT**
Information on patent family members

| International application No. |
| --- |
| **PCT/CN2023/129722** |

| Patent document cited in search report | | | Publication date (day/month/year) | Patent family member(s) | | | Publication date (day/month/year) |
| --- | --- | --- | --- | --- | --- | --- | --- |
| CN | 109888867 | A | 14 June 2019 | None | | | |
| CN | 114786441 | A | 22 July 2022 | None | | | |
| CN | 110875641 | A | 10 March 2020 | US | 2020076244 | A1 | 05 March 2020 |
| | | | | US | 10658878 | B2 | 19 May 2020 |
| | | | | WO | 2020046487 | A1 | 05 March 2020 |
| CN | 112349999 | A | 09 February 2021 | None | | | |
| CN | 114204629 | A | 18 March 2022 | None | | | |
| CN | 115413204 | A | 29 November 2022 | None | | | |
| CN | 113949115 | A | 18 January 2022 | None | | | |
| KR | 20180128250 | A | 03 December 2018 | KR | 101949426 | B1 | 18 February 2019 |
| US | 2019241087 | A1 | 08 August 2019 | TW | 201935826 | A | 01 September 2019 |
| | | | | WO | 2019156781 | A1 | 15 August 2019 |
| | | | | US | 10875417 | B2 | 29 December 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211526999